(19) Europäisches Patentamt / European Patent Office / Office européen des brevets

(11) **EP 4 049 185 B1**

(12) **EUROPEAN PATENT SPECIFICATION**

(45) Date of publication and mention of the grant of the patent:
**26.11.2025 Bulletin 2025/48**

(21) Application number: **20790202.4**

(22) Date of filing: **01.10.2020**

(51) International Patent Classification (IPC):
**G06N 3/04** (2023.01)     **G06N 3/063** (2023.01)

(52) Cooperative Patent Classification (CPC):
**G06N 3/063; G06N 3/048; G06N 3/0499**

(86) International application number:
**PCT/EP2020/077486**

(87) International publication number:
**WO 2021/078486 (29.04.2021 Gazette 2021/17)**

(54) **3D NEURAL INFERENCE PROCESSING UNIT ARCHITECTURES**

3D-ARCHITEKTUREN FÜR NEURONALE INFERENZPROZESSOREN

ARCHITECTURES D'UNITÉ DE TRAITEMENT D'INFÉRENCE NEURONALE 3D

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **24.10.2019 US 201916662532**

(43) Date of publication of application:
**31.08.2022 Bulletin 2022/35**

(73) Proprietor: **International Business Machines Corporation**
**Armonk, New York 10504 (US)**

(72) Inventors:
 • **CASSIDY, Andrew**
   **Austin, Texas 78758-3400 (US)**
 • **AKOPYAN, Filipp**
   **Yorktown Heights, New York 10598 (US)**
 • **APPUSWAMY, Rathinakumar**
   **San Jose, California 95120-6099 (US)**
 • **ARTHUR, John**
   **San Jose, California 95120-6099 (US)**
 • **DATTA, Pallab**
   **San Jose, California 95120-6099 (US)**
 • **DEBOLE, Michael**
   **San Jose, California 95120-6099 (US)**
 • **ESSER, Steve**
   **San Jose, California 95120-6099 (US)**
 • **FLICKNER, Myron**
   **San Jose, California 95120-6099 (US)**
 • **MODHA, Dharmendra**
   **San Jose, California 95120-6099 (US)**
 • **ORTEGA OTERO, Carlos**
   **San Jose, California 95120-6099 (US)**
 • **SAWADA, Jun**
   **Austin, Texas 78758-3400 (US)**

(74) Representative: **IBM United Kingdom Limited**
**Intellectual Property Law**
**Hursley Park**
**Winchester, Hampshire SO21 2JN (GB)**

(56) References cited:
**US-A1- 2019 303 749**

## Description

### BACKGROUND

Embodiments of the present disclosure relate to neural network processing, and more specifically, to three-dimensional neural inference processing unit architectures. US 2019/0303749 A1 (Appuswamy et al) discloses massively parallel neural inference computing elements. A plurality of multipliers is arranged in a plurality of equal-sized groups. Each of the plurality of multipliers is adapted to, in parallel, apply a weight to an input activation to generate an output. A plurality of adders is operatively coupled to one of the groups of multipliers. Each of the plurality of adders is adapted to, in parallel, add the outputs of the multipliers within its associated group to generate a partial sum. A plurality of function blocks is operatively coupled to one of the plurality of adders. Each of the plurality of function blocks is adapted to, in parallel, apply a function to the partial sum of its associated adder to generate an output value.

### BRIEF SUMMARY

According to the present disclosure, a neural inference chip is provided as claimed in claim 1.

A method of and computer program product for neural inference processing are also provided, not forming part of the claimed invention.

### BRIEF DESCRIPTION OF THE SEVERAL VIEWS OF THE DRAWINGS

**Fig. 1** illustrates a neural core according to embodiments of the present disclosure.

**Fig. 2** illustrates an exemplary Inference Processing Unit (IPU) according to embodiments of the present disclosure.

**Fig. 3** illustrates a multi-core Inference Processing Unit (IPU) according to embodiments of the present disclosure.

**Fig. 4** illustrates a single tier layout of a multi-core Inference Processing Unit (IPU) according to embodiments of the present disclosure.

**Fig. 5** illustrates a two-tier layout of a multi-core Inference Processing Unit (IPU) according to embodiments of the present disclosure.

**Fig. 6** illustrates a multi-tier layout of a multi-core Inference Processing Unit (IPU) according to embodiments of the present disclosure.

**Fig. 7** illustrates a multi-tier layout of a multi-core Inference Processing Unit (IPU) according to embodiments of the present disclosure.

**Fig. 8** illustrates a multi-tier layout of a multi-core Inference Processing Unit (IPU) according to embodiments of the present disclosure.

**Figs. 9A-G** illustrate a three-dimensional global memory interconnect according to embodiments of the present disclosure.

**Fig. 10** depicts a computing node according to an embodiment of the present disclosure

### DETAILED DESCRIPTION

An artificial neuron is a mathematical function whose output is a nonlinear function of a linear combination of its inputs. Two neurons are connected if the output of one is an input to the other. A weight is a scalar value encoding the strength of the connection between the output of one neuron and the input of another neuron.

A neuron computes its output, called an activation, by applying a nonlinear activation function to a weighted sum of its inputs. A weighted sum is an intermediate result computed by multiplying each input with the corresponding weight and accumulating the products. A partial sum is a weighted sum of a subset of inputs. A weighted sum of all inputs may be computed in stages by accumulating one or more partial sums.

A neural network is a collection of one or more neurons. A neural network is often divided into groups of neurons called layers. A layer is a collection of one or more neurons that all receive input from the same layers and all send output to the same layers, and typically perform a similar function. An input layer is a layer that receives input from a source outside the neural network. An output layer is a layer that sends output to a target outside the neural network. All other layers are intermediate processing layers. A multilayer neural network is a neural network with more than one layer. A deep neural network is a multilayer neural network with many layers.

A tensor is a multidimensional array of numerical values. A tensor block is a contiguous subarray of the elements in a tensor.

Each neural network layer is associated with a parameter tensor $V$, weight tensor $W$, input data tensor X, output data tensor Y, and intermediate data tensor Z. The parameter tensor contains all of the parameters that control neuron activation functions σ in the layer. The weight tensor contains all of the weights that connect inputs to the layer. The input data tensor contains all of the data that the layer consumes as input. The output data tensor contains all of the data that the layer computes as output. The intermediate data tensor contains any data that the layer produces as intermediate computations, such as partial sums.

The data tensors (input, output, and intermediate) for a layer may be 3-dimensional, where the first two dimensions may be interpreted as encoding spatial location and the third dimension as encoding different features. For example, when a data tensor represents a color image, the first two dimensions encode vertical and horizontal coordinates within the image, and the third dimension encodes the color at each location. Every element of the input data tensor $X$ can be connected to every neuron by a separate weight, so the weight tensor $W$ generally has 6 dimensions, concatenating the 3 dimensions of the input data tensor (input row $a$, input column b, input feature c) with the 3 dimensions of the output data tensor (output row $i$, output column $j$, output feature $k$). The intermediate data tensor Z has the same shape as the output data tensor Y. The parameter tensor $V$ concatenates the 3 output data tensor dimensions with an additional dimension o that indexes the parameters of the activation function $\sigma$.

An element of a layer's output data tensor Y can be computed as in Equation 1 where the neuron activation function $\sigma$ is configured by the vector of activation function parameters $V[i, j, k, :]$, and the weighted sum $Z[i, j, k]$ can be computed as in Equation 2.

$$Y[i,j,k] = \sigma(V[i,j,k,:]; \ Z[i,j,k])$$

*Equation 1*

$$Z[i,j,k] = \sum_{a=1}^{A}\sum_{b=1}^{B}\sum_{c=1}^{C} W[i,j,k,a,b,c] \cdot X[a,b,c]$$

*Equation 2*

For simplicity of notation, the weighted sum in Equation 2 may be referred to as the output, which is equivalent to using a linear activation function $Y[i,j,k] = \sigma(Z[i, j, k]) = Z[i, j, k]$, with the understanding that the same statements apply without loss of generality when a different activation function is used.

In various embodiments, computation of the output data tensor as described above is decomposed into smaller problems. Each problem may then be solved on one or more neural core, or on one or more core of a conventional multicore system in parallel.

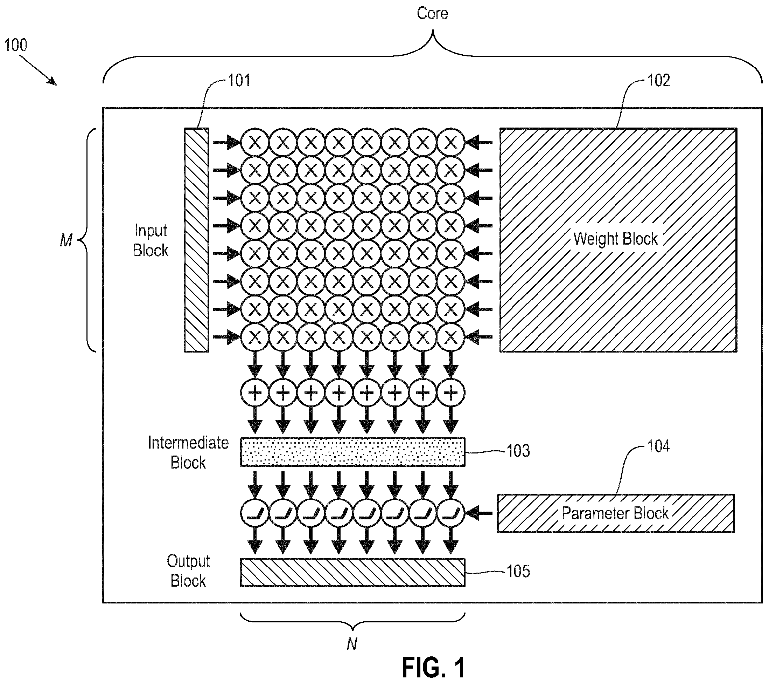

With reference now to Fig. 1, a neural core according to embodiments of the present disclosure is depicted. A neural core 100 is a tileable computational unit that computes one block of an output tensor. A neural core 100 has $M$ inputs and $N$ outputs. In various embodiments, $M = N$. To compute an output tensor block, a neural core multiplies an $M \times 1$ input tensor block 101 with an $M \times N$ weight tensor block 102 and accumulates the products into weighted sums that are stored in a $1 \times N$ intermediate tensor block 103. A $O \times N$ parameter tensor block contains the $O$ parameters that specify each of the N neuron activation functions that are applied to the intermediate tensor block 103 to produce a $1 \times N$ output tensor block 105.

Multiple neural cores may be tiled in a neural core array. In some embodiments, the array is 2-dimensional.

A neural network model is a set of constants that collectively specify the entire computation performed by a neural network, including the graph of connections between neurons as well as the weights and activation function parameters for every neuron. Training is the process of modifying the neural network model to perform a desired function. Inference is the process of applying a neural network to an input to produce an output, without modifying the neural network model.

An inference processing unit is a category of processors that perform neural network inference. A neural inference chip is a specific physical instance of an inference processing unit.

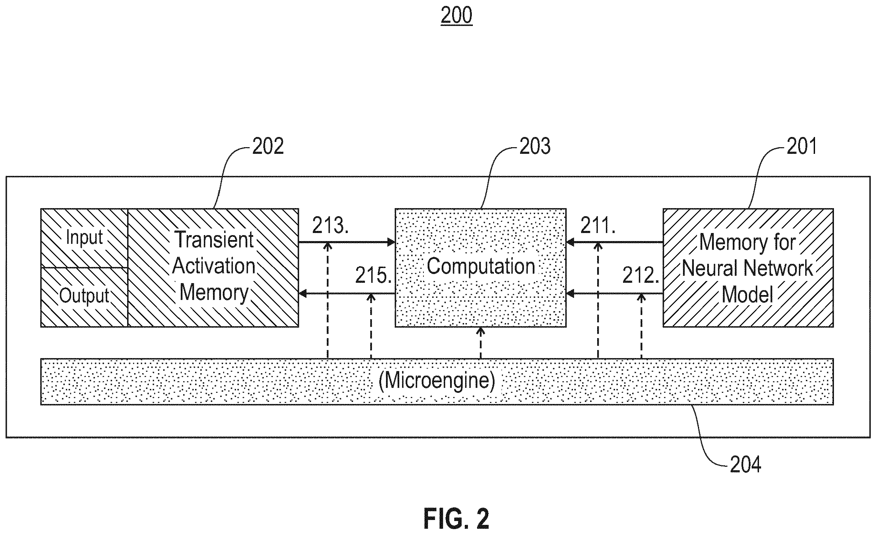

Referring to **Fig. 2,** an exemplary Inference Processing Unit (IPU) is illustrated according to embodiments of the present disclosure. IPU 200 includes a memory 201 for the neural network model. As described above, the neural network model may include the synapse weights for a neural network to be computed. IPU 200 includes an activation memory 202, which may be transient. Activation memory 202 may be divided into input and output regions, and stores neuron activations for processing. IPU 200 includes a neural computation unit 203, which is loaded with a neural network model from model memory 201. Input activations are provided from activation memory 202 in advance of each computation step. Outputs from neural computation unit 203 are written back to activation memory 202 for processing on the same or another neural computation unit.

In various embodiments a microengine 204 is included in IPU 200. In such embodiments, all operations in the IPU are directed by the microengine. As set out below, central and/or distributed microengines may be provided in various embodiments. A global microengine may be referred to as a chip microengine, while a local microengine may be referred to as a core microengine or local controller. In various embodiments a microengine comprises one or more microengines, microcontrollers, state machines, CPUs, or other controllers.

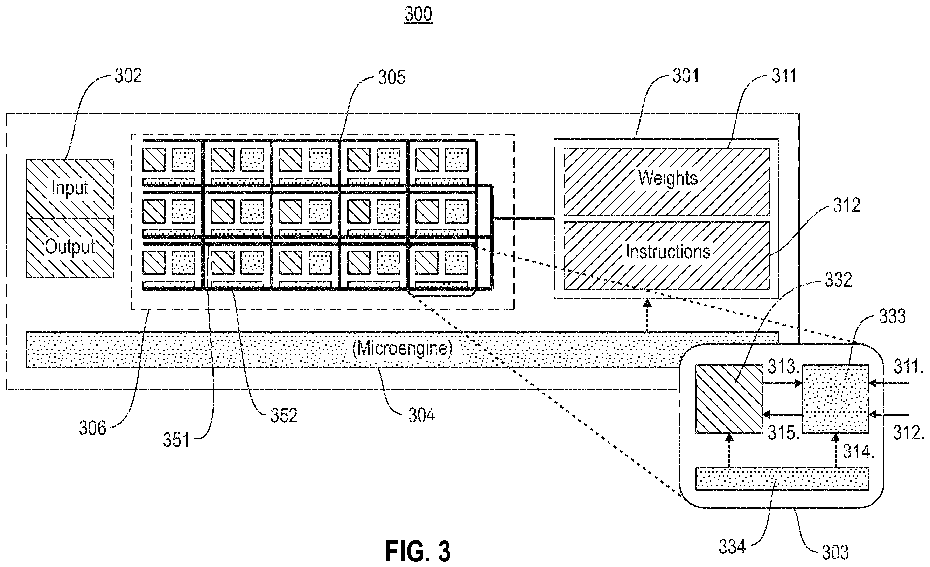

Referring to **Fig. 3,** a multi-core Inference Processing Unit (IPU) is illustrated according to embodiments of the present disclosure. IPU **300** includes a memory **301** for the neural network model and instructions. In some embodiments, memory **301** is divided into weigh portion **311** and instruction portion **312.** As described above, the neural network model may include the synapse weights for a neural network to be computed. IPU **300** includes an activation memory **302,** which may be transient. Activation memory **302** may be divided into input and output regions, and stores neuron activations for processing. IPU **300** includes a plurality of cores **303.** Each core **303** includes a neural computation unit **333,** which is loaded with a neural network model from model memory **301.** Each core also include a local activation memory **332.** Input activations are provided from local activation memory **332** in advance of each computation step. Outputs from neural computation unit **333** are written back to activation memory **332** for processing on the same or another neural computation unit.

IPU **300** includes an array **306** of neural cores **303.** Each core **303** includes a computation unit **333,** which is loaded with a neural network model from model memory **301** and is operative to perform vector computation. Each core also includes a local activation memory **332.** Input activations are provided from local activation memory **332** in advance of each computation step. Outputs from computation unit **333** are written back to activation memory **332** for processing on the same or another computation unit.

IPU **300** includes one or more network-on-chip (NoC) **305.** In some embodiments, a partial sum NoC **351** interconnects the cores **303** and transports partial sums among them. In some embodiments, a separate parameter distribution NoC **352** connects cores **303** to memory **301** for distributing weights and instructions to cores **303.** It will be appreciated that various configurations of NoC **351** and **352** are suitable for use according to the present disclosure. For example, broadcast networks, row broadcast networks, tree networks, and switched networks may be used.

In various embodiments a global microengine **304** is included in IPU **300.** In various embodiments, a local core controller **334** is included on each core **303.** In such embodiments, the direction of operations is shared between the global microengine (chip microengine) and the local core controller (core microengine). In particular, at **311,** compute instructions are loaded from model memory **301** to the neural computation unit **333** on each core **303** by global microengine **304.** At **312,** parameters (e.g., neural network/synaptic weights) are loaded from model memory **301** to the neural computation unit **333** on each core **303** by global microengine **304.** At **313,** neural network activation data are loaded from activation local activation memory **332** to neural computation unit **333** on each core **303** by local core controller **334.** As noted above, the activations are provided to the axons of the particular neural network defined by the model, and may originate from the same or another neural computation unit, or from outside the system. At **314,** neural computation unit **333** performs the computation to generate output neuron activations as directed by local core controller **334.** In particular, the computation comprises applying the input synaptic weights to the input activations. It will be appreciated that various methods are available for performing such computations, including *in silico* dendrites, as well as vector multiplication units. At **315,** the results from computation are stored in local activation memory **332** as directed by local core controller **334.** As described above, these stages may be pipelined, in order to provide efficient usage of the neural computation unit on each core. It will also be appreciated that inputs and outputs may be transferred from local activation memory **332** to global activation memory **302** according to the requirements of a given neural network.

Computation unit **333** performs the computation to generate output neuron activations as directed by local core controller **334.** In particular, the computation comprises applying the input synaptic weights to the input activations. It will be appreciated that various methods are available for performing such computations, including in *silico* dendrites, as well as vector multiplication units. The results from computation are stored in local activation memory **332** as directed by local core controller **334.** These stages may be pipelined, in order to provide efficient usage of the computation unit on each core. It will also be appreciated that inputs and outputs may be transferred from local activation memory **332** to global activation memory **302** according to the requirements of a given neural network.

Accordingly, the present disclosure provides for runtime control of operations in an Inference Processing Unit (IPU). In some embodiments, the microengine is centralized (single microengine). In some embodiments, the IPU computation is distributed (performed by an array of cores). In some embodiments, runtime control of operations is hierarchical - both a central microengine and distributed microengines participate.

The microengine or microengines direct the execution of all operations in the IPU. Each microengine instruction corresponds to several sub-operations (e.g., address generation, load, compute, store, etc.) In the distributed case, core microcode is run on the core microengines (*e.g.,* **334**). The core microcode includes instruction(s) to execute a full, single tensor operation. For example, a convolution between a weight tensor and a data tensor. In the context of a single core, the core microcode includes instruction(s) to execute a single tensor operation on the locally stored subset of the data tensor (and partial sums). Chip microcode is run on the chip microengine (e.g., **404).** Microcode includes instructions to execute all of the tensor operations in a neural network.

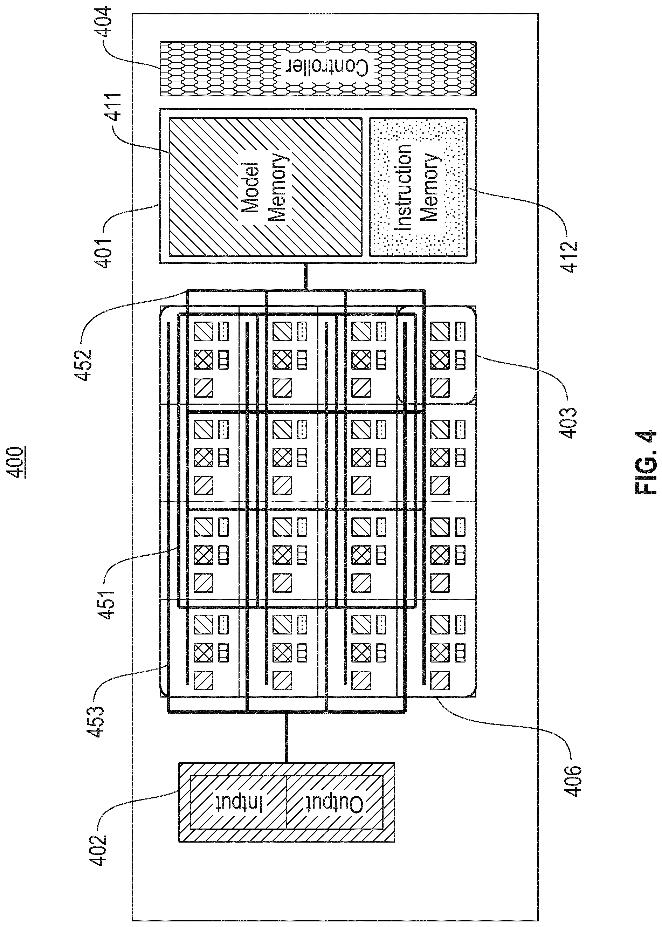

Referring now to **Fig. 4,** an exemplary single layer layout of a multi-core Inference Processing Unit (IPU) is illustrated according to embodiments of the present disclosure. As in **Fig. 3,** IPU **400** includes a memory **401** for the neural network model and instructions. As described above, the neural network model may include the synapse weights for a neural network to be computed. IPU **400** includes an activation memory **402,** which may be transient. Activation memory **402** may be divided into input and output regions, and stores neuron activations for processing.

IPU **400** includes an array **406** of neural cores **403.** Each core **403** includes a computation unit, which is loaded with a neural network model from model memory **401** and is operative to perform vector computation. In various embodiments, each core also includes a local activation memory. In such embodiments, input activations are provided from local activation memory in advance of each computation step. Outputs from the computation unit are written back to activation memory for processing on the same or another computation unit. In various embodiments, each core **403** includes a local model memory, instruction memory, controller, and/or activation memory.

IPU **400** includes one or more network-on-chip (NoC). In some embodiments, a partial sum NoC **451** interconnects the cores **403** and transports partial sums among them. In some embodiments, a separate parameter distribution NoC **452** connects cores **403** to memory **401** for distributing weights and instructions to cores **403.** In some embodiments, activation NoC 453 connects cores to activation memory **402.** It will be appreciated that various configurations of NoC **451, 452,** and **453** are suitable for use according to the present disclosure. For example, broadcast networks, row broadcast networks, tree networks, and switched networks may be used.

In various embodiments a global microengine **404** is included in IPU **400.** In various embodiments, a local core controller is included on each core **403.** In such embodiments, the direction of operations is shared between the global microengine (chip microengine) and the local core controller (core microengine). In particular, compute instructions are loaded from model memory **401** to the neural computation unit on each core **403** by global microengine **404.** Parameters (*e.g.*, neural network/synaptic weights) are loaded from model memory **401** to the neural computation unit on each core **403** by global microengine **404.** Neural network activation data are loaded from activation local activation memory to the neural computation unit on each core **403** by a local core controller. As noted above, the activations are provided to the axons of the particular neural network defined by the model, and may originate from the same or another neural computation unit, or from outside the system.

The neural computation unit performs the computation to generate output neuron activations as directed by the local core controller. In particular, the computation comprises applying the input synaptic weights to the input activations. It will be appreciated that various methods are available for performing such computations, including in *silico* dendrites, as well as vector multiplication units. The results from computation are stored in local activation memory as directed by local core controller. As described above, these stages may be pipelined, in order to provide efficient usage of the neural computation unit on each core. It will also be appreciated that inputs and outputs may be transferred from local activation memory to global activation memory **402** according to the requirements of a given neural network.

In **Fig. 4,** the components of IPU **400** are laid out on a single layer. In an exemplary embodiment, the layout is distributed approximately as follows: 5% of the overall chip area is devoted to activation I/O, 60% is devoted to the core array, 25% is devoted to global memory, 5% is devoted to the global memory interconnect (IC), and 5% is devoted to the controller. Within a given core, approximately 25% is devoted to activation memory, 25% to weight memory, 25% to computation, and 25% to control.

Various limitations on performance are imposed by this architecture. For example, memory capacity imposes limitations on network size. In particular, the size of global weight memory determines the maximum neural network model size that can be computed. The size of activation memory determines the largest network layer that can be computed. Similarly, wire bandwidth limits the network distribution (weight distribution) and determines the maximum compute parallelism. Data movement distance limits energy efficiency.

In order to address these limitations imposed by the physical layout of a given chip, in embodiments according to the claimed invention, a 3D layout is adopted, in which the various chip components are spread over multiple layers or tiers. In these embodiments, this is achieved through silicon 3D die and wafer stacking. Furthermore, in these embodiments, inter-tier connectivity is provided by through silicon vias.

A through-silicon via (TSV) or through-chip via is a vertical electrical connection (via) that passes completely through a silicon wafer or die. TSVs are high performance interconnect techniques used as an alternative to wire-bond and flip chips to create 3D packages and 3D integrated circuits. Compared to alternatives such as package-on-package, the interconnect and device density is substantially higher, and the length of the connections becomes shorter.

In various embodiments, TSVs have interconnect pitches of 6-10 $\mu$m, enabling high interconnect densities of ~1-3 million interconnects/cm$^2$. Given a 500$\mu$m by 500$\mu$m area (250,000 $\mu$m$^2$), a 10 $\mu$m pitch yields 2500 interconnects (250,000 $\mu$m$^2$ / (10 $\mu$m x 10 $\mu$m)) and a 6 $\mu$m pitch yields 6944 interconnects (250,000 $\mu$m$^2$ / (6 $\mu$m x 6 $\mu$m)). Alternative implementations may have 1.6-3.0 $\mu$m pitch with 6-10um depth.

The TSV may be implemented, for example, in copper based on a 14nm process. Such an exemplary embodiment may have a diameter of about 10 $\mu$m and a pitch of about 40 $\mu$m. The TSV may be implemented for example, in tungsten. Such an exemplary embodiment may have a diameter of about 1.2 $\mu$m and a pitch of about 2.5 $\mu$m. Another such exemplary embodiment may have a diameter of about 1.0 $\mu$m with a 2.0 $\mu$m pitch.

In various embodiments, a 3D layout is coupled with a 2D global weight distribution bus. In this way, unique bandwidth to cores (and potentially total bandwidth to cores) is increased.

As set out below, 3D layouts are scalable over two or more layers, achieving increased capacity and inter-tier wire length minimization.

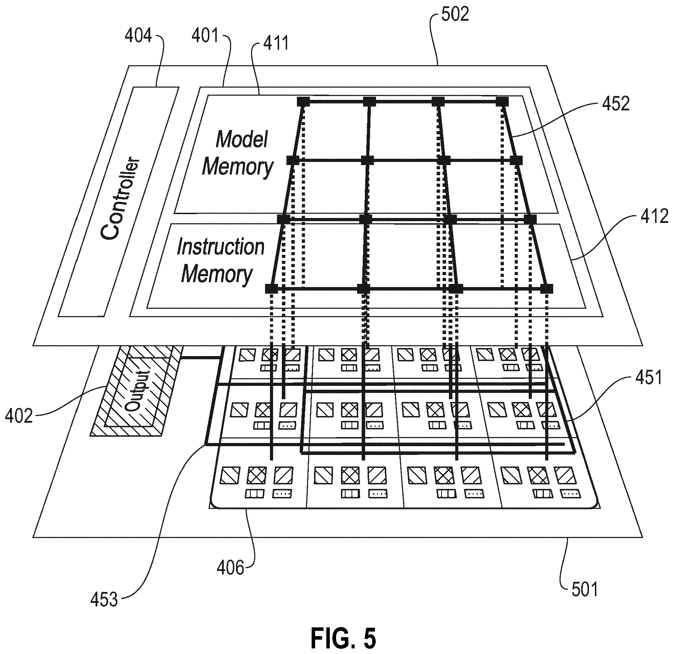

Fig. 5 illustrates an exemplary two-tier layout. In this layout, first tier 501 includes the core array and activation I/O components. Second tier 502 includes the global memory, global memory interconnect, and controller. Parameter distribution NoC 452 is configured as a mesh network connecting each core for parameter distribution.

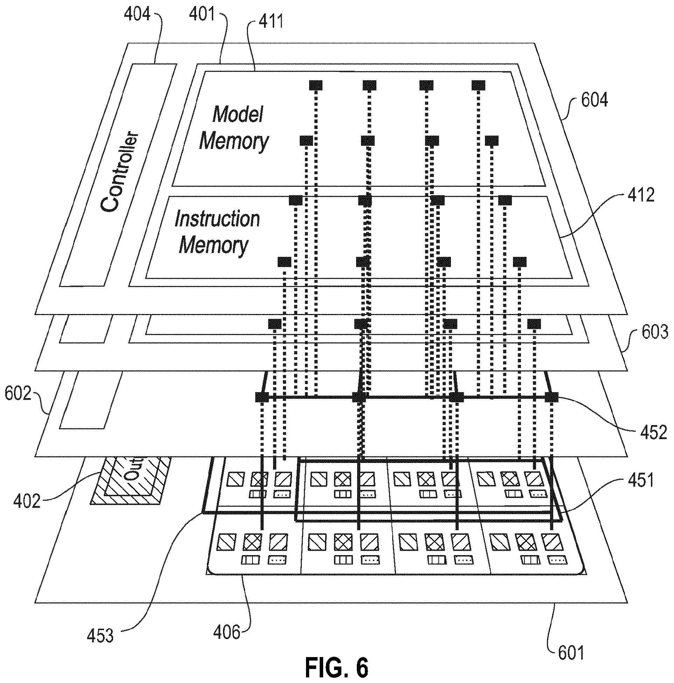

Fig. 6 illustrates an exemplary n-tier layout. In this layout, first tier 601 includes the core array and activation I/O components. Second tier 602 includes the global memory interconnect. Additional tiers 603...604 include the global memory. It will be appreciated that the global memory may be spread among an arbitrary number of layers, thereby scaling capacity without changing the overall physical footprint of each tier.

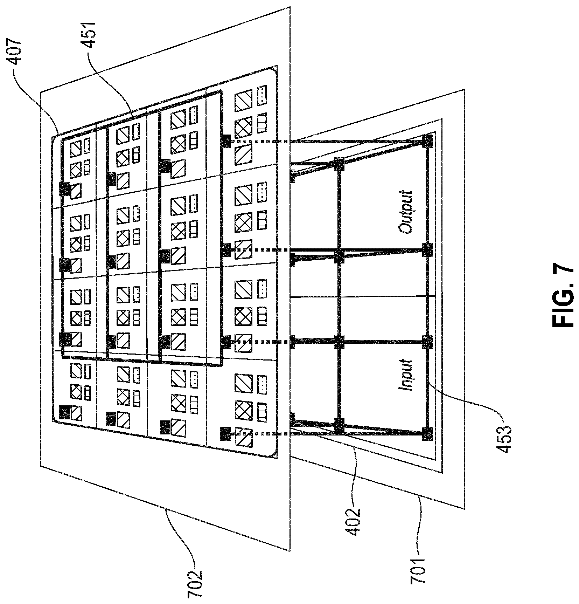

Fig. 7 illustrates an exemplary n-tier layout. In this layout, first tier 701 includes the activation I/O components, including the activation memory and network 453. Second tier 702 includes the core array. Additional tiers (not shown) include the global memory, global memory interconnect, and controller (for example, as pictured in Figs. 5-6).

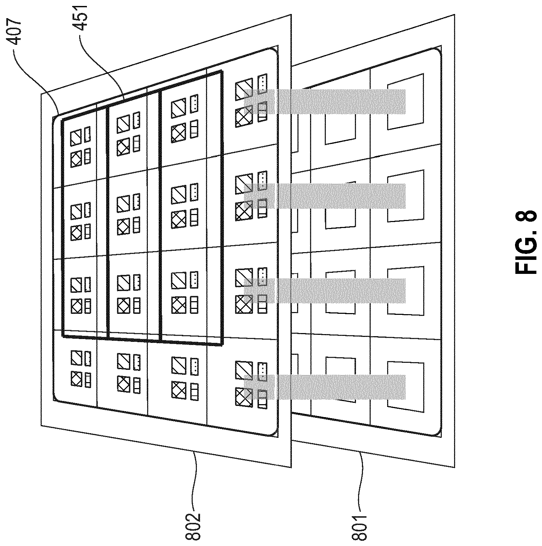

Fig. 8 illustrates an exemplary n-tier layout. In this layout, the cores are divided among multiple tiers. Tier 801 includes the activation memory for each core. Tier 802 includes the computation, weight memory, and controller for each core. An additional layer (not shown) includes the activation I/O components (such as pictured in Fig. 7). Additional tiers (not shown) include the global memory, global memory interconnect, and controller (for example, as pictured in Figs. 5-6). In this example, the core activation memory size can scale up by 2-4x (holding all else constant) by virtue of having its own tier.

In view of the above examples, it will be appreciated that additional multi-tiered layouts may be adopted in various embodiments. For example, a memory array may be sandwiched between two core arrays. In such an embodiment, the model is in the middle and it distributes the weights to the core array tiers above and below. Such an embodiment is particularly useful in cases having a batch size of two. In particular, for a given model, a first image is processed on the top core array tier, and a second image is processed on the bottom core array tier. This embodiment is also useful for redundant computation in high-reliability settings. A single image may be processed simultaneously on top and bottom tiers. The results from both tiers can be compared. If they match, the neural inference computation was successful. If not, the computation may be repeated, or the faulty system may be diagnosed.

Neural network layers may be split among two tiers. For example, neural network layers 1-5 could be processed on the bottom tier, and neural network layers 6-10 processed on the top tier. Similarly, different neural networks may be run on the same (or different) images simultaneously on different tiers.

The multi-tier approach described above results in a bandwidth improvement over single-tier architectures. In particular, the wire area increases from 1D to 2D. The wire pitch decreases from the minimum wire spacing to the TSV spacing. The core array weight distribution buses go from shared to individual. Bus frequency increases due to the short TSV propagation distance (corresponding to depth). As a result, activation memory bandwidth and weight distribution bandwidth is increased.

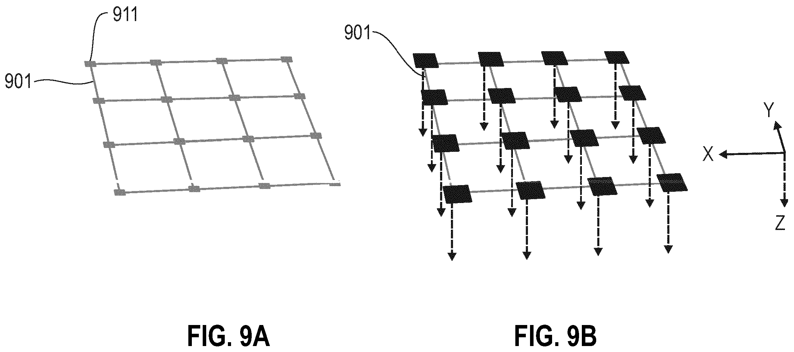

Referring now to Figs. 9A-G , a 3D global memory interconnect is illustrated according to embodiments of the present disclosure. A 3D mesh communication network 901 (see Fig. 9A) is provided, which allows dimension ordered routing. In particular, messages are routed on the first and second dimensions (e.g., X and Y) within a tier, and then on the third dimension (e.g., Z) between tiers. The tier destination node (e.g., 911), upon receipt of a message, sends along a third dimension to a core array on another tier (e.g., immediately below). For example, communication network 452 may be implemented in this manner, as pictured in Figs. 5-6. It will be appreciated that the other NoCs described herein may also be implemented in this manner, for example communication network 453 as pictured in Fig. 7.

Referring to Fig. 9B, individual bank distribution is illustrated on communication network 901. In this example, each node in communication network 901 sends an individualized weight block from one memory bank to one core along the third dimension.

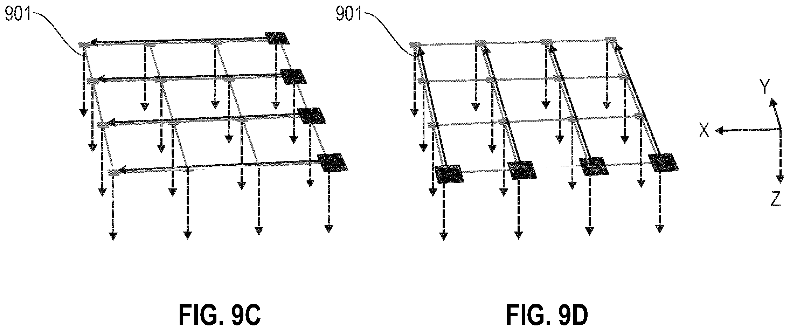

Referring to Fig. 9C, a row broadcast is illustrated on communication network 901. In this example, a weight block is distributed from a row memory bank to each node along a row, and then routed to the cores along the third dimension. In this way, each core in a given row receives the same data.

Referring to Fig. 9D, a column broadcast is illustrated on communication network 901. In this example, a weight block is distributed from a column memory bank to each node along a column, and then routed to the cores along the third dimension. In this way, each core in a given column receives the same data.

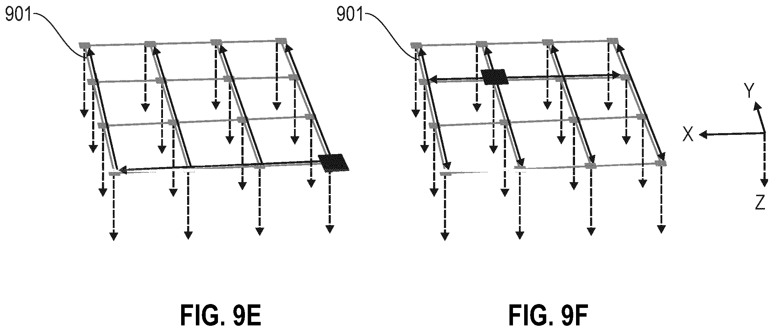

Referring to Fig. 9E, a single bank broadcast is illustrated on communication network 901. In this example, a weight block is distributed from one single memory bank to every other node in the array, and then routed to the cores along the third dimension. In this way, each core receives the same data.

Referring to Fig. 9F, a single bank broadcast is illustrated on communication network 901. In this example, a weight block is distributed from a single interior memory bank to every other node in the array, and then routed to the cores along the third dimension. In this way, each core receives the same data.

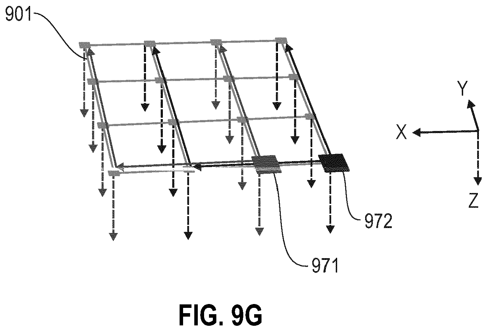

Referring to **Fig. 9G,** a multi-bank broadcast is illustrated on communication network **901.** In this example, a weight block is distributed from node **971,** while a different weight block is distributed from node **972.** The respective blocks are routed along rows and columns to respective subsets of cores. In this way, a concurrent multicast is achieved.

In various embodiments, each tier of silicon has a wire stack. The wire stack and wire pitch define the maximum number of wires that can be manufactured within a tier. This, along with frequency, defines the maximum bandwidth achievable within a tier. By using multiple tiers, the effective number of wires, and effective bandwidth are both increased, directly proportional to the number of tiers.

In various embodiments, described above, a second tier is used for the global memory communication network. This gives more wiring capacity for the global memory communication network in the second tier. In addition, this frees up more wiring capacity for the other communication networks (e.g., the partial sum NoC and activation NoC) in the first tier.

Various embodiments provide scalable capacity. In particular, every added tier of memory adds capacity. This additionally allows modular fabrication, for example allowing multiple product lines with different memory capacities, using the same base logic tiers.

In various embodiments, DRAM, FLASH, SRAM, or other memory technologies are integrated on separate tiers together with standard logic process tiers.

In various embodiments, the overall energy reduction may be computed using Equation 3, where $N_{wires}$ is the number of wires, C is the total line capacitance, $V_{dd}$ is the power supply voltage, $b$ is the average fraction of bits in a packet that switch ($0 \rightarrow 1$ or $1 \rightarrow 0$), $U_{wires}$ is the wire utilization, and $f$ is the clock frequency. In an exemplary embodiment, $b = 0.5$ and f = $10^9 Hz$. Capacitance is proportional to distance, and so moving to an average distance of 10-100 $\mu$m from 4 mm results in a 40-400x reduction in weight distribution NoC energy consumption.

$$P_{wire\_channel} = N_{wires} \times C \times V_{dd}^2 \times b \times U_{wires} \times f$$

*Equation 3*

As described herein, in various embodiments an IPU is divided among multiple tiers. In particular, neural inference chips are provided in which a core array and memory are implemented on different silicon tiers. In various embodiments, the memory capacity is scalable by adding (or subtracting) memory tiers. In various embodiments, weight or parameter memory are provided on dedicated memory tiers. In various embodiments, activation memory is provided on a dedicated memory tier.

In various embodiments, a dedicated memory bus is provided to each core, in contrast to a shared row bus. In various embodiments, weights are distributed to the core array via a dedicated bus to each core. In various embodiments, the dedicated buses are routed to each core via a different silicon tier.

In various embodiments, a global memory interconnect is provided. Such a system provides configurable broadcast of data between a 2D array of memory banks and a 2D array of compute cores on different silicon tiers. In various embodiments, the data is routed to the core array via a different silicon tier.

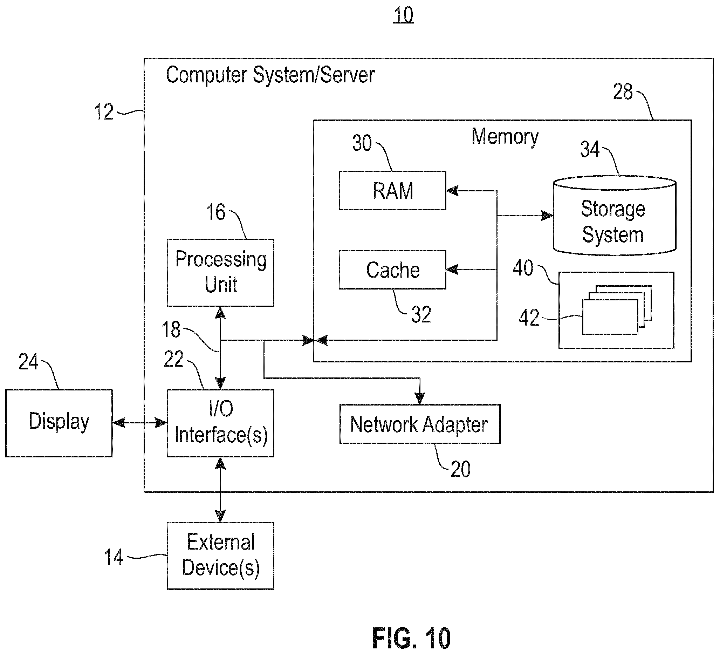

Referring now to **Fig. 10,** a schematic of an example of a computing node is shown. Computing node 10 is only one example of a suitable computing node and is not intended to suggest any limitation as to the scope of use or functionality of embodiments described herein. Regardless, computing node 10 is capable of being implemented and/or performing any of the functionality set forth hereinabove.

In computing node **10** there is a computer system/server **12,** which is operational with numerous other general purpose or special purpose computing system environments or configurations. Examples of well-known computing systems, environments, and/or configurations that may be suitable for use with computer system/server **12** include, but are not limited to, personal computer systems, server computer systems, thin clients, thick clients, handheld or laptop devices, multiprocessor systems, microprocessor-based systems, set top boxes, programmable consumer electronics, network PCs, minicomputer systems, mainframe computer systems, and distributed cloud computing environments that include any of the above systems or devices, and the like.

Computer system/server **12** may be described in the general context of computer system-executable instructions, such as program modules, being executed by a computer system. Generally, program modules may include routines, programs, objects, components, logic, data structures, and so on that perform particular tasks or implement particular abstract data types. Computer system/server **12** may be practiced in distributed cloud computing environments where tasks are performed by remote processing devices that are linked through a communications network. In a distributed cloud computing environment, program modules may be located in both local and remote computer system storage media including memory storage devices.

As shown in **Fig. 10,** computer system/server **12** in computing node **10** is shown in the form of a general-purpose computing device. The components of computer system/server **12** may include, but are not limited to, one or more processors or processing units **16,** a system memory **28,** and a bus **18** that couples various system components including system memory **28** to processor **16.**

Bus **18** represents one or more of any of several types of bus structures, including a memory bus or memory controller, a peripheral bus, an accelerated graphics port, and a processor or local bus using any of a variety of bus architectures. By way of example, and not limitation, such architectures include Industry Standard Architecture (ISA) bus, Micro Channel Architecture (MCA) bus, Enhanced ISA (EISA) bus, Video Electronics Standards Association (VESA) local bus, Peripheral Component Interconnect (PCI) bus, Peripheral Component Interconnect Express (PCIe), and Advanced Microcontroller Bus Architecture (AMBA).

In various embodiments, one or more inference processing unit (not pictured) is coupled to bus **18.** In such embodiments, an IPU may receive data from or write data to memory **28** via bus **18.** Likewise, an IPU may interact with other components via bus **18** as described herein.

Computer system/server **12** typically includes a variety of computer system readable media. Such media may be any available media that is accessible by computer system/server **12,** and it includes both volatile and non-volatile media, removable and non-removable media.

System memory **28** can include computer system readable media in the form of volatile memory, such as random access memory (RAM) **30** and/or cache memory **32.** Computer system/server **12** may further include other removable/non-removable, volatile/non-volatile computer system storage media. By way of example only, storage system **34** can be provided for reading from and writing to a non-removable, non-volatile magnetic media (not shown and typically called a "hard drive"). Although not shown, a magnetic disk drive for reading from and writing to a removable, non-volatile magnetic disk (e.g., a "floppy disk"), and an optical disk drive for reading from or writing to a removable, non-volatile optical disk such as a CD-ROM, DVD-ROM or other optical media can be provided. In such instances, each can be connected to bus **18** by one or more data media interfaces. As will be further depicted and described below, memory **28** may include at least one program product having a set (e.g., at least one) of program modules that are configured to carry out the functions of embodiments of the disclosure.

Program/utility **40,** having a set (at least one) of program modules **42,** may be stored in memory **28** by way of example, and not limitation, as well as an operating system, one or more application programs, other program modules, and program data. Each of the operating system, one or more application programs, other program modules, and program data or some combination thereof, may include an implementation of a networking environment. Program modules **42** generally carry out the functions and/or methodologies of embodiments as described herein.

Computer system/server **12** may also communicate with one or more external devices **14** such as a keyboard, a pointing device, a display **24,** etc.; one or more devices that enable a user to interact with computer system/server **12;** and/or any devices (*e.g.*, network card, modem, etc.) that enable computer system/server **12** to communicate with one or more other computing devices. Such communication can occur via Input/Output (I/O) interfaces **22.** Still yet, computer system/server **12** can communicate with one or more networks such as a local area network (LAN), a general wide area network (WAN), and/or a public network (e.g., the Internet) via network adapter **20.** As depicted, network adapter **20** communicates with the other components of computer system/server **12** via bus **18.** It should be understood that although not shown, other hardware and/or software components could be used in conjunction with computer system/server **12.** Examples, include, but are not limited to: microcode, device drivers, redundant processing units, external disk drive arrays, RAID systems, tape drives, and data archival storage systems, etc.

The present disclosure may be embodied as a system, a method, and/or a computer program product. The computer program product may include a computer readable storage medium (or media) having computer readable program instructions thereon for causing a processor to carry out aspects of the present disclosure.

The computer readable storage medium can be a tangible device that can retain and store instructions for use by an instruction execution device. The computer readable storage medium may be, for example, but is not limited to, an electronic storage device, a magnetic storage device, an optical storage device, an electromagnetic storage device, a semiconductor storage device, or any suitable combination of the foregoing. A non-exhaustive list of more specific examples of the computer readable storage medium includes the following: a portable computer diskette, a hard disk, a random access memory (RAM), a read-only memory (ROM), an erasable programmable read-only memory (EPROM or Flash memory), a static random access memory (SRAM), a portable compact disc read-only memory (CD-ROM), a digital versatile disk (DVD), a memory stick, a floppy disk, a mechanically encoded device such as punch-cards or raised structures in a groove having instructions recorded thereon, and any suitable combination of the foregoing. A computer readable storage medium, as used herein, is not to be construed as being transitory signals per se, such as radio waves or other freely propagating electromagnetic waves, electromagnetic waves propagating through a waveguide or other transmission media (*e.g.*, light pulses passing through a fiber-optic cable), or electrical signals transmitted through a wire.

Computer readable program instructions described herein can be downloaded to respective computing/processing devices from a computer readable storage medium or to an external computer or external storage device via a network, for example, the Internet, a local area network, a wide area network and/or a wireless network. The network may comprise copper transmission cables, optical transmission fibers, wireless transmission, routers, firewalls, switches, gateway computers and/or edge servers. A network adapter card or network interface in each computing/processing device receives computer readable program instructions from the network and forwards the computer readable program instructions for storage in a computer readable storage medium within the respective computing/processing device.

Computer readable program instructions for carrying out operations of the present disclosure may be assembler instructions, instruction-set-architecture (ISA) instructions, machine instructions, machine dependent instructions, microcode, firmware instructions, state-setting data, or either source code or object code written in any combination of one or more programming languages, including an object oriented programming language such as Smalltalk, C++ or the like, and conventional procedural programming languages, such as the "C" programming language or similar programming languages. The computer readable program instructions may execute entirely on the user's computer, partly on the user's computer, as a stand-alone software package, partly on the user's computer and partly on a remote computer or entirely on the remote computer or server. In the latter scenario, the remote computer may be connected to the user's computer through any type of network, including a local area network (LAN) or a wide area network (WAN), or the connection may be made to an external computer (for example, through the Internet using an Internet Service Provider). In some embodiments, electronic circuitry including, for example, programmable logic circuitry, field-programmable gate arrays (FPGA), or programmable logic arrays (PLA) may execute the computer readable program instructions by utilizing state information of the computer readable program instructions to personalize the electronic circuitry, in order to perform aspects of the present disclosure.

Aspects of the present disclosure are described herein with reference to flowchart illustrations and/or block diagrams of methods, apparatus (systems), and computer program products according to embodiments of the disclosure. It will be understood that each block of the flowchart illustrations and/or block diagrams, and combinations of blocks in the flowchart illustrations and/or block diagrams, can be implemented by computer readable program instructions.

These computer readable program instructions may be provided to a processor of a general purpose computer, special purpose computer, or other programmable data processing apparatus to produce a machine, such that the instructions, which execute via the processor of the computer or other programmable data processing apparatus, create means for implementing the functions/acts specified in the flowchart and/or block diagram block or blocks. These computer readable program instructions may also be stored in a computer readable storage medium that can direct a computer, a programmable data processing apparatus, and/or other devices to function in a particular manner, such that the computer readable storage medium having instructions stored therein comprises an article of manufacture including instructions which implement aspects of the function/act specified in the flowchart and/or block diagram block or blocks.

The computer readable program instructions may also be loaded onto a computer, other programmable data processing apparatus, or other device to cause a series of operational steps to be performed on the computer, other programmable apparatus or other device to produce a computer implemented process, such that the instructions which execute on the computer, other programmable apparatus, or other device implement the functions/acts specified in the flowchart and/or block diagram block or blocks.

The flowchart and block diagrams in the Figures illustrate the architecture, functionality, and operation of possible implementations of systems, methods, and computer program products according to various embodiments of the present disclosure. In this regard, each block in the flowchart or block diagrams may represent a module, segment, or portion of instructions, which comprises one or more executable instructions for implementing the specified logical function(s). It will also be noted that each block of the block diagrams and/or flowchart illustration, and combinations of blocks in the block diagrams and/or flowchart illustration, can be implemented by special purpose hardware-based systems that perform the specified functions or acts or carry out combinations of special purpose hardware and computer instructions.

**Claims**

1. A neural inference chip wherein the layout of the chip uses silicon 3D die and wafer stacking including a plurality of silicon tiers, comprising:

   a first silicon tier (601) comprising a plurality of neural cores (306), each core (303) comprising:
   a neural computation unit (333), the neural computation unit (333) adapted to apply a plurality of synaptic weights to a plurality of input activations to produce a plurality of output activations;
   a second silicon tier (604) comprising a first neural network model memory (301) adapted to store the plurality of synaptic weights; and
   a communication network operatively coupled to the first neural network model memory (301) and to each of the plurality of neural cores, and adapted to provide the synaptic weights from the first neural network model memory (301) to each of the plurality of neural cores (306), wherein the communication network comprises a plurality of through-silicon vias providing connectivity between the first silicon tier (601) and the second silicon tier (604), and wherein the communication network has at least three dimensions, a first of the at least three dimensions extending between silicon tiers of the neural inference chip, and a second of the at least three dimensions extending within a silicon tier of the neural inference chip.

2. The neural inference chip of claim 1, further comprising:

   at least one additional silicon tier comprising at least one additional neural network model memory, wherein the communication network is additionally operatively coupled to the at least one additional neural network model memory and adapted to provide synaptic weights from the at least one additional neural network model memory to each of the plurality of neural cores (306).

3. The neural inference chip of claim 2, wherein a neural network model is stored across the first neural network model memory (301) and the at least one additional neural network model memory.

4. The neural inference chip of claim 2, wherein a plurality of neural network models are stored across the first neural network model memory (301) and the at least one additional neural network model memory.

5. The neural inference chip of claim 1, wherein each core further comprises:

   an activation memory (332) adapted to store the input activations and the output activations;
   a local controller, the local controller being adapted to load the input activations from the activation memory (332) to the neural computation unit (333) and to store the plurality of output activations from the neural computation unit (333) to the activation memory (332).

6. The neural inference chip of claim 1, further comprising:

   a third silicon tier comprising an activation memory, wherein
   the communication network is additionally operatively coupled to the activation memory and adapted to provide activations from the activation memory to each of the plurality of neural cores (306).

7. The neural inference chip of claim 1, further comprising:

   a third silicon tier comprising an activation memory, wherein
   an additional communication network is operatively coupled to the activation memory and adapted to provide activations from the activation memory to each of the plurality of neural cores (306).

8. The neural inference chip of claim 1, further comprising:

   a third silicon tier comprising a plurality of neural cores, wherein
   the communication network is operatively coupled to the third silicon tier and adapted to provide the synaptic weights from the first neural network model memory (301) to each of the plurality of neural cores (306) of the third silicon tier.

9. The neural inference chip of claim 8, configured to provide a first neural network model (301) to both the first (601) and third silicon tiers.

10. The neural inference chip of claim 8, configured to provide different neural network models to each of the first and third silicon tiers.

11. The neural inference chip of claim 1, wherein the communication network is adapted to provide the same synaptic weights to each of the cores.

12. The neural inference chip of claim 1, wherein the communication network is adapted to provide the same synaptic weights to a subset of the cores.

13. The neural inference chip of claim 1, wherein the communication network is configured to provide a dedicated bus for each of the cores.

**Patentansprüche**

1. Neuronaler Inferenzchip, wobei beim Layout des Chips 3D-Silicium-Die- und Wafer-Stapelung angewendet werden, umfassend eine Mehrzahl von Siliciumebenen, aufweisend:
eine erste Siliciumebene (601), welche eine Mehrzahl von neuronalen Kernen (306) aufweist, wobei jeder Kern (303) aufweist:

eine neuronale Berechnungseinheit (333), wobei die neuronale Berechnungseinheit (333) zum Anwenden einer Mehrzahl von synaptischen Gewichtungen auf eine Mehrzahl von Eingabeaktivierungen geeignet ist, um eine Mehrzahl von Ausgabeaktivierungen zu erzeugen;
eine zweite Siliciumebene (604), welche einen ersten Speicher (301) eines neuronalen Netzmodells aufweist, der zum Speichern der Mehrzahl von synaptischen Gewichtungen geeignet ist; und
ein Kommunikationsnetzwerk, welches operativ mit dem ersten Speicher (301) des neuronalen Netzmodells und mit jedem der Mehrzahl von neuronalen Kernen verbunden ist und dafür geeignet ist, die synaptischen Gewichtungen aus dem ersten Speicher (301) des neuronalen Netzmodells jedem der Mehrzahl von neuronalen Kernen (306) bereitzustellen, wobei das Kommunikationsnetzwerk eine Mehrzahl von Durchkontaktierungen durch Silicium aufweist, welche für Verbindungsmöglichkeiten zwischen der ersten Siliciumebene (601) und der zweiten Siliciumebene (604) sorgen, und wobei das Kommunikationsnetzwerk mindestens drei Dimensionen aufweist, wobei sich eine erste der mindestens drei Dimensionen zwischen Siliciumebenen des neuronalen Inferenzchips erstreckt und eine zweite der mindestens drei Dimensionen sich innerhalb einer Siliciumebene des neuronalen Inferenzchips erstreckt.

2. Neuronaler Inferenzchip nach Anspruch 1, ferner aufweisend:
mindestens eine weitere Siliciumebene, welche mindestens einen weiteren Speicher eines neuronalen Netzmodells aufweist, wobei das Kommunikationsnetzwerk zusätzlich operativ mit dem mindestens einen weiteren Speicher des neuronalen Netzmodells verbunden ist und dafür geeignet ist, jedem der Mehrzahl von neuronalen Kernen (306) synaptische Gewichtungen aus dem mindestens einen weiteren Speicher des neuronalen Netzmodells bereitzustellen.

3. Neuronaler Inferenzchip nach Anspruch 2, wobei ein neuronales Netzmodell über den ersten Speicher (301) des neuronalen Netzmodells und den mindestens einen weiteren Speicher des neuronalen Netzmodells gespeichert ist.

4. Neuronaler Inferenzchip nach Anspruch 2, wobei eine Mehrzahl von neuronalen Netzmodellen über den ersten Speicher (301) des neuronalen Netzmodells und den mindestens einen weiteren Speicher des neuronalen Netzmodells gespeichert sind.

5. Neuronaler Inferenzchip nach Anspruch 1, wobei jeder Kern ferner aufweist:

einen Aktivierungsspeicher (332), welcher zum Speichern der Eingabeaktivierungen und der Ausgabeaktivierungen geeignet ist;
eine lokale Steuerung, wobei die lokale Steuerung zum Laden der Eingabeaktivierungen aus dem Aktivierungsspeicher (332) in die neuronale Berechnungseinheit (333) und zum Speichern der Mehrzahl von Ausgabeaktivierungen aus der neuronalen Berechnungseinheit (333) in den Aktivierungsspeicher (332) geeignet ist.

6. Neuronaler Inferenzchip nach Anspruch 1, ferner aufweisend:

eine dritte Siliciumebene, welche einen Aktivierungsspeicher aufweist, wobei
das Kommunikationsnetzwerk zusätzlich operativ mit dem Aktivierungsspeicher verbunden ist und dafür geeignet ist, jedem der Mehrzahl von neuronalen Kernen (306) Aktivierungen aus dem Aktivierungsspeicher bereitzustellen.

7. Neuronaler Inferenzchip nach Anspruch 1, ferner aufweisend:

eine dritte Siliciumebene, welche einen Aktivierungsspeicher aufweist, wobei
ein zusätzliches Kommunikationsnetzwerk operativ mit dem Aktivierungsspeicher verbunden ist und dafür geeignet ist, jedem der Mehrzahl von neuronalen Kernen (306) Aktivierungen aus dem Aktivierungsspeicher bereitzustellen.

8. Neuronaler Inferenzchip nach Anspruch 1, ferner aufweisend:

eine dritte Siliciumebene, welche eine Mehrzahl von neuronalen Kernen aufweist, wobei

das Kommunikationsnetzwerk operativ mit der dritten Siliciumebene verbunden ist und dafür geeignet ist, jedem der Mehrzahl von neuronalen Kernen (306) der dritten Siliciumebene die synaptischen Gewichtungen aus dem ersten Speicher (301) des neuronalen Netzmodells bereitzustellen.

9. Neuronaler Inferenzchip nach Anspruch 8, welcher so konfiguriert ist, dass er sowohl der ersten (601) als auch der dritten Siliciumebene ein erstes neuronales Netzmodell (301) bereitstellt.

10. Neuronaler Inferenzchip nach Anspruch 8, welcher so konfiguriert ist, dass er der ersten und der dritten Siliciumebene jeweils andere neuronale Netzmodelle bereitstellt.

11. Neuronaler Inferenzchip nach Anspruch 1, wobei das Kommunikationsnetzwerk dafür geeignet ist, jedem der Kerne die gleichen synaptischen Gewichtungen bereitzustellen.

12. Neuronaler Inferenzchip nach Anspruch 1, wobei das Kommunikationsnetzwerk dafür geeignet ist, einer Teilgruppe der Kerne die gleichen synaptischen Gewichtungen bereitzustellen.

13. Neuronaler Inferenzchip nach Anspruch 1, wobei das Kommunikationsnetzwerk so konfiguriert ist, dass es jedem der Kerne einen für diesen vorgesehenen Bus bereitstellt.

## Revendications

1. Puce d'inférence neuronale dans laquelle la disposition de la puce utilise une puce de silicium 3D et un empilement de plaquettes comportant une pluralité de niveaux de silicium, comprenant :
   un premier niveau de silicium (601) comprenant une pluralité de cœurs neuronaux (306), chaque cœur (303) comprenant :

   une unité de calcul neuronal (333), l'unité de calcul neuronal (333) étant adaptée pour appliquer une pluralité de poids synaptiques à une pluralité d'activations d'entrée pour produire une pluralité d'activations de sortie ;
   un deuxième niveau de silicium (604) comprenant une mémoire modèle de premier réseau neuronal (301) adaptée pour enregistrer la pluralité des poids synaptiques ; et
   un réseau de communication couplé opérationnellement à la mémoire modèle de premier réseau neuronal (301) et à chacun de la pluralité des cœurs neuronaux, et adapté pour fournir les poids synaptiques à partir de la mémoire modèle de premier réseau neuronal (301) à chacun de la pluralité des cœurs neuronaux (306), dans laquelle le réseau de communication comprend une pluralité d'interconnexions traversant le silicium fournissant une connectivité entre le premier niveau de silicium (601) et le deuxième niveau de silicium (604), et dans laquelle le réseau de communication possède au moins trois dimensions, une première des au moins trois dimensions s'étendant entre des niveaux de silicium de la puce d'inférence neuronale, et une deuxième des au moins trois dimensions s'étendant à l'intérieur d'un niveau de silicium de la puce d'inférence neuronale.

2. Puce d'inférence neuronale selon la revendication **1,** comprenant en outre :
   au moins un niveau de silicium supplémentaire comprenant au moins une mémoire modèle de réseau neuronal supplémentaire, dans laquelle le réseau de communication est en supplément couplé opérationnellement à l'au moins une mémoire modèle de réseau neuronal supplémentaire et adapté pour fournir des poids synaptiques à partir de l'au moins une mémoire modèle de réseau neuronal supplémentaire à chacun de la pluralité des cœurs neuronaux (306).

3. Puce d'inférence neuronale selon la revendication 2, dans laquelle un modèle de réseau neuronal est enregistré dans l'ensemble de la mémoire modèle de premier réseau neuronal (301) et l'au moins une mémoire modèle de réseau neuronal supplémentaire.

4. Puce d'inférence neuronale selon la revendication 2, dans laquelle une pluralité de modèles de réseaux neuronaux est enregistrée dans l'ensemble de la mémoire modèle de premier réseau neuronal (301) et l'au moins une mémoire modèle de réseau neuronal supplémentaire.

5. Puce d'inférence neuronale selon la revendication 1, dans laquelle chaque cœur comprend en outre :

   une mémoire d'activation (332) adaptée pour enregistrer les activations d'entrée et les activations de sortie ;

un dispositif de commande local, le dispositif de commande local étant adapté pour charger les activations d'entrée à partir de la mémoire d'activation (332) vers l'unité de calcul neuronal (333) et pour enregistrer la pluralité des activations de sortie à partir de l'unité de calcul neuronal (333) vers la mémoire d'activation (332).

6. Puce d'inférence neuronale selon la revendication 1, comprenant en outre :

un troisième niveau de silicium comprenant une mémoire d'activation, dans laquelle
le réseau de communication est en plus couplé opérationnellement à la mémoire d'activation et adapté pour fournir des activations à partir de la mémoire d'activation à chacun de la pluralité des cœurs neuronaux (306).

7. Puce d'inférence neuronale selon la revendication 1, comprenant en outre :

un troisième niveau de silicium comprenant une mémoire d'activation, dans laquelle
un réseau de communication supplémentaire est couplé opérationnellement à la mémoire d'activation et adapté pour fournir des activations à partir de la mémoire d'activation vers chacun de la pluralité des cœurs neuronaux (306).

8. Puce d'inférence neuronale selon la revendication 1, comprenant en outre :

un troisième niveau de silicium comprenant une pluralité de cœurs neuronaux, dans laquelle
le réseau de communication est couplé opérationnellement au troisième niveau de silicium et adapté pour fournir les poids synaptiques à partir de la mémoire modèle de premier réseau neuronal (301) à chacun de la pluralité des cœurs neuronaux (306) du troisième niveau de silicium.

9. Puce d'inférence neuronale selon la revendication 8, configurée pour fournir un premier modèle de réseau neuronal (301) à la fois au premier (601) et au troisième niveau de silicium.

10. Puce d'inférence neuronale selon la revendication 8, configurée pour fournir des modèles de réseaux neuronaux différents à chacun parmi le premier et le troisième niveau de silicium.

11. Puce d'inférence neuronale selon la revendication 1, dans laquelle le réseau de communication est adapté pour fournir les mêmes poids synaptiques à chacun des cœurs.

12. Puce d'inférence neuronale selon la revendication 1, dans laquelle le réseau de communication est adapté pour fournir les mêmes poids synaptiques à un sous-ensemble de cœurs.

13. Puce d'inférence neuronale selon la revendication 1, dans laquelle le réseau de communication est configurée pour fournir un bus dédié pour chacun des cœurs.

**FIG. 1**

**FIG. 2**

EP 4 049 185 B1

**FIG. 3**

EP 4 049 185 B1

**FIG. 4**

EP 4 049 185 B1

FIG. 5

EP 4 049 185 B1

**FIG. 6**

EP 4 049 185 B1

**FIG. 7**

EP 4 049 185 B1

FIG. 8

EP 4 049 185 B1

**FIG. 9A**

**FIG. 9B**

FIG. 9D

FIG. 9C

FIG. 9E

FIG. 9F

EP 4 049 185 B1

**FIG. 9G**

FIG. 10

EP 4 049 185 B1

# EP 4 049 185 B1

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- US 20190303749 A1, Appuswamy